# EUROPÄISCHE PATENTSCHRIFT

(11) **EP 4 173 031 B1**
(45) Veröffentlichungstag und Bekanntmachung des Hinweises auf die Patenterteilung: **03.06.2026**
(21) Anmeldenummer: 21754752.0
(22) Anmeldetag: 27.07.2021
(51) Int. Cl.: H10W 90/00, H10W 76/15

(54) **LEISTUNGSHALBLEITERMODULSYSTEM UND HERSTELLUNGSVERFAHREN FÜR EIN LEISTUNGSHALBLEITERMODULSYSTEM**
POWER SEMICONDUCTOR MODULE SYSTEM AND METHOD FOR MANUFACTURING A POWER SEMICONDUCTOR MODULE SYSTEM
SYSTÈME DE MODULE À SEMI-CONDUCTEUR DE PUISSANCE ET PROCÉDÉ DE FABRICATION POUR UN SYSTÈME DE MODULE À SEMI-CONDUCTEUR DE PUISSANCE

(30) Priorität: 05.08.2020 EP 20189702
(43) Veröffentlichungstag der Anmeldung: 03.05.2023
(73) Patentinhaber: Siemens Aktiengesellschaft, 80333 München (DE)
(72) Erfinder: LORZ, Roland, 91341 Röttenbach (DE); KNEISSL, Philipp, 90427 Nürnberg (DE)
(74) Vertreter: Siemens Patent Attorneys
(86) Internationale Anmeldenummer: PCT/EP2021/071023
(87) Internationale Veröffentlichungsnummer: WO 2022/028957

(56) Entgegenhaltungen:
- EP-A2- 0 750 345
- DE-A1- 102014 115 812
- DE-A1- 19 646 396
- US-A1- 2006 274 561
- US-A1- 2011 310 585
- US-A1- 2014 231 982
- US-A1- 2014 367 736

## Beschreibung

Die Erfindung betrifft ein Leistungshalbleitermodulsystem. Zudem betrifft die Erfindung ein Gehäuse für ein Leistungshalbleitermodulsystem. Außerdem betrifft die Erfindung einen Leistungshalbleitermodulsystemzusammenschluss und ein Verfahren zum Herstellen eines Leistungshalbleitermodulsystems.

Leistungshalbleiterschaltungen werden zumeist in Gehäusen verpackt. Vor allem für höhere Leistungen werden mehrere Leistungshalbleiterschaltungen in einem Gehäuse integriert, um höhere Ströme zu erreichen. Oftmals werden die Halbleiter einer "Halbbrücke" zusammen in ein Gehäuse integriert, um eine niederinduktive Verschaltung zu gewährleisten.

Das Gehäuse hat viele unterschiedliche Aufgaben zu erfüllen, aus diesem Grunde ist der Entwicklungsaufwand und der Herstellungsaufwand (Spritzgussformen, Biegewergzeuge, Automatisierung etc.) sehr hoch und ist somit nur für hohe Stückzahlen profitabel.

Wenn die Leistung eines Leistungshalbleitermoduls noch größer werden soll, so muss eine andere und größere Leistungshalbleiterschaltung eingesetzt werden, um die benötigte Halbleiterfläche unterzubringen. Grundsätzlich sinken die Stückzahlen für Leistungshalbleitermodule mit zunehmendem maximalen Modulnennstrom (Chipfläche), d.h. je größer die Module desto geringer die benötigten/erzielbaren Modulstückzahlen.

Andererseits steigt mit der Modulgröße auch die Komplexität des Moduls. Die Aufwände für die Konstruktion, vor allem der Bodenplatte und des Gehäuses, steigen überproportional. Gleiches gilt für den eigentlichen Herstellungsprozess. Hier kann zum einen die Anzahl der notwendigen Prozessschritte (z.B. bei mehrmaligem Löten). Zum anderen können andere Prozessschritte notwendig sein, z.B. Ultraschallschweißen. Das macht sich dann vor allem durch eine höhere Ausschussrate (Yield) bemerkbar. Zusätzlich ist für geringe Leistungshalbleitermodulstückzahlen ein hoher Fertigungsautomatisierungsgrad finanziell nicht rentabel.

Alternativ kann die Leistung eines Leistungshalbleitermoduls auch erhöht werden, indem man mehrere Leistungshalbleiterschaltungen innerhalb des Leistungshalbleitermoduls parallelschaltet. Hierfür muss man eine Verschienung der einzelnen Leistungshalbleiterschaltungen, den Treiber und das Kühlsystem speziell ausgestalten, um eine ausreichende statische und dynamische Stromsymmetrie sicherzustellen. Auch das Design des Leistungshalbleitermoduls selbst (die elektrischen Anschlüsse und das interne Layout) können einen signifikanten Einfluss auf die Stromverteilung innerhalb des Leistungshalbleitermoduls haben.

Zusätzlich müssen die parallel geschalteten Module in der Regel von ihren elektrischen Eigenschaften, z.B. der Flussspannung zueinander, selektiert werden. Dies kann vor allem für die Logistik bzw. für einen Reparaturfall sehr komplex sein.

Um das Problem der geringen Stückzahlen und des hohen Ausschusses bei großen Leistungshalbleitermodulen zu verbessern bzw. zu beheben, können unterschiedliche Ausführungen zum Einsatz können. Das Leistungshalbleitermodul kann in kleinere Teileinheiten zerlegt werden. Diese Teileinheiten werden dann soweit wie möglich vorgetestet.

Schaltungsträger wie DCBs (Direct Copper Bonds) können soweit wie möglich vorproduziert werden, z.B. durch Verlöten der Chips und Bonden der Verbindungen innerhalb der DCB. Diese vorproduzierten DCBs können dann mit niedriger Spannung getestet werden. Diese Tests können aber nur einen Teil der möglichen Fehler detektieren.

Die einzelnen Teileinheiten werden nachfolgend dann zu einem kompletten Leistungshalbleitermodul zusammengefügt und um die weiteren Komponenten (z.B. Bodenplatte, Gehäuse, Kontaktelektroden, Gel etc.) ergänzt. Nach dem Zusammenfügen können dann am Schluss das Leistungshalbleitermodul einer vollständigen elektrischen Prüfung unterzogen werden.

In der EP 1 467 607 B1 ist ein Leistungsschaltermodul mit an einem Gehäuse eines Leistungshalbleiters angebrachten Kontaktelektroden offenbart.

Die DE 20 2013 105 809 U1 offenbart ein Leistungshalbleitermodul und eine Kontaktierungsanordnung zur Kontaktierung von Schaltelement-Kontakten.

Die US 2011/0310585 A1 offenbart ein Leistungshalbleitermodul mit einer Vielzahl von Leistungshalbleiterelementen.

In der DE 196 46 396 A1 ist ein Leistungshalbleitermodul beschrieben, das durch Variation von Leistungsschaltern, Dioden und Widerständen eine multivariable Schaltungsbreite bei hoher Packungsdichte induktivitätsarm ermöglicht.

Die US 2006/0274561 A1 offenbart ein Inverter-Leistungsmodul, welches eine Architektur aufweist, die einen hohen Modularitätsgrad ermöglicht.

Der Erfindung liegt die Aufgabe zugrunde, ein Leistungshalbleitermodulsystem und ein dazugehöriges Herstellungsverfahren anzugeben, das eine einfache und effiziente Skalierung eines zu schaltenden elektrischen Stromes ermöglicht.

Diese Aufgabe wird gelöst durch ein Leistungshalbleitermodulsystem nach Anspruch 1. Außerdem wird die Aufgabe gelöst durch ein Gehäuse für ein Leistungshalbleitermodulsystem nach Anspruch 10. Außerdem wird die Aufgabe gelöst durch ein Leistungshalbleitermodulsystemzusammenschluss nach Anspruch 11 und ein Verfahren zum Herstellen eines Leistungshalbleitermodulsystems nach Anspruch 12. Vorteilhafte Weiterbildungen ergeben sich aus den abhängigen Ansprüchen.

Gemäß Anspruch 1 weist ein erfindungsgemäßes Leistungshalbleitermodulsystem zwei Leistungshalbleitermodule mit einem gemeinsamen Gehäuse auf. Dabei weist jedes Leistungshalbleitermodul eine Leistungshalbleiterschaltung auf, wobei das gemeinsame Gehäuse die beiden Leistungshalbleiterschaltungen wenigstens teilweise umgibt, und wobei die Leistungshalbleitermodule jeweils eine erste Kontaktelektrode und eine zweite Kontaktelektrode aufweisen, die jeweils mit der Leistungshalbleiterschaltung elektrisch leitend verbunden sind, und die jeweils durch eine hierfür ausgebildete Ausnehmung in dem gemeinsamen Gehäuse durch das Gehäuse nach außen geführt sind, wobei das gemeinsame Gehäuse einen ersten, einen zweiten und einen dritten Kontaktierungsbereich aufweist, und wobei in dem ersten Kontaktierungsbereich die erste Kontaktelektrode und die zweite Kontaktelektrode des ersten Leistungshalbleitermoduls kontaktiert sind, und wobei in dem zweiten Kontaktierungsbereich die erste Kontaktelektrode und die zweite Kontaktelektrode des zweiten Leistungshalbleitermoduls kontaktiert sind, und wobei in dem dritten Kontaktierungsbereich die zweite Kontaktelektrode des ersten Leistungshalbleitermoduls und die zweite Kontaktelektrode des zweiten Leistungshalbleitermoduls zusammen kontaktiert sind.

Die Leistungshalbleiterschaltung kann zum Steuern und Schalten von elektrischen Strömen eingesetzt werden, die eine vergleichsweise große Stromstärke aufweisen, beispielsweise mehr als 50 Ampere. Die Leistungshalbleiterschaltung kann auf einem Substrat angeordnete Leistungshalbleiterbauelemente, wie z.B. IGBTs (Insulated Gate Bipolar Transistor), MOSFETs (Metal Oxide Semiconductor Field Effect Transistor), Thyristoren, Dioden und dergleichen umfassen, die mittels einer Leiterschicht des Substrats, sowie Bonddrähten und/oder einem Folienverbund miteinander elektrisch leitend verbunden sein können. Die auf dem Substrat angeordneten Leistungshalbleiterbauelemente können elektrisch zu einer einzelnen oder mehreren sogenannten Halbbrückenschaltungen verschalten sein, die z.B. zum Gleich- und Wechselrichten von elektrischen Spannungen und Strömen verwendet werden.

Zu den Aufgaben eines Gehäuses für ein Leistungshalbleitermodulsystem können die mechanische Entlastung, das Führen und die Isolation der einzelnen Kontaktelektroden zählen. Im Rahmen der Erfindung kann ein beliebiges Gehäuse eingesetzt werden, welches die beiden Leistungshalbleiterschaltungen wenigstens teilweise umgibt, um u.a. die oben genannten Funktionen zu erfüllen. Es liegt gleichsam im Rahmen der Erfindung, wenn die beiden Leistungshalbleitermodule zusätzliche (getrennte) Gehäuse aufweisen, die in Form eines Vergussrahmens die einzelnen Leistungshalbleitermodule (teilweise) umgibt. Es ist zudem möglich, dass das "gemeinsame Gehäuse" im Sinn der Erfindung ein Art "Gehäusedeckel" darstellt, der beide Leistungshalbleitermodule und die darin enthaltenen Leistungshalbleiterschaltungen überdeckt.

Die Kontaktelektroden haben die Aufgabe, eine elektrische Leistung auf die Halbleiterschaltung zu übertragen.

Hierzu sind die Kontaktelektroden derart ausgebildet, dass sie mit einer externen Spannungs-/Stromquelle elektrisch leitend verbunden werden können (z.B. durch Löten, Schweißen oder eine mechanische Verbindung wie Quetschen oder Schrauben). Die Kontaktelektroden müssen zu diesem Zweck wenigstens in Teilbereichen eine nicht zu vernachlässigende elektrische Leitfähigkeit aufweisen, um die Leistung an die Halbleiterschaltung leiten zu können. Die Kontaktelektroden können beispielsweise aus Kupfer, Eisennickel oder elektrisch leitendem Silizium sein.

Das erfindungsgemäße Leistungshalbleitermodulsystem weist ein Gehäuse mit wenigstens drei Kontaktierungsbereichen auf. Diese sind dafür vorgesehen, dass jeweils zwei Kontaktelektroden in jeweils einem der Kontaktierungsbereiche an dem Gehäuse kontaktierbar sind.

Das erfindungsgemäße Leistungshalbleitermodulsystem ermöglicht es, zwei komplett autarke Leistungshalbleitermodule für den Einsatz bei höheren Leistungen miteinander auf einfache Art und Weise miteinander mechanisch und elektrisch zu verbinden, ohne dass hierfür eine Änderung an den eigentlichen Leitungshalbleiterschaltungen vorgenommen werden müsste. Vorteilhafterweise ist es nun möglich, dass die einzelnen Leistungshalbleitermodule nicht direkt nebeneinander gruppiert sind, wodurch die entstehende Verlustleistung nicht so stark konzentriert ist. Folglich kann das Design eines für das Leistungshalbleitermodulsystems erforderlichen Kühlsystems deutlich erleichtert werden.

Die Anschlussfläche/Kontaktierungsmöglichkeiten nehmen durch das erfindungsgemäßes Leistungshalbleitermodulsystem zu. Die einzelnen Leistungshalbleitermodule können schon vorproduziert und endgeprüft werden, bevor sie zu dem großen Leistungshalbleitermodulsystem zusammengesetzt werden. Insgesamt ergibt sich weniger Ausschuss (höherer "Yield" bei der Modulfertigung). Damit einhergehend sinkt auch der Wert des eventuell defekten Einzelteils und somit verbessert sich die Kostenposition.

Bevorzugt sind in dem ersten Kontaktierungsbereich die erste Kontaktelektrode und die zweite Kontaktelektrode des ersten Leistungshalbleitermoduls zusammen mit einer externen Spannungs-/Stromquelle kontaktiert, und in dem zweiten Kontaktierungsbereich sind die erste Kontaktelektrode und die zweite Kontaktelektrode des zweiten Leistungshalbleitermoduls zusammen mit einer externen Spannungs-/Stromquelle kontaktiert, und in dem dritten Kontaktierungsbereich sind die zweite Kontaktelektrode des ersten Leistungshalbleitermoduls und die zweite Kontaktelektrode des zweiten Leistungshalbleitermoduls zusammen mit einer externen Spannungs-/Stromquelle kontaktiert. Bei der jeweiligen externen Spannungs-/Stromquelle handelt es sich vorteilhafterweise um eine einzige (um dieselbe) Spannungs-/Stromquelle.

Die Anzahl der Kontaktelektroden und der Kontaktierungsbereiche ist nicht auf die zuvor erläuterte Zahl begrenzt. Es handelt sich vielmehr um eine Minimalkonfiguration. Demnach kann das Leistungshalbleitermodulsystem ein ganzzahliges Vielfaches von zwei ersten und zwei zweiten Kontaktelektroden und ein Vielfaches von drei Kontaktierungsbereichen aufweisen, wobei die Kontaktelektroden und die Kontaktierungsbereiche an dem Gehäuse jeweils wie zuvor erläutert ausgebildet sind. Es ist beispielsweise möglich, dass das Gehäuse neun Kontaktierungsbereiche aufweist, und dass jedes Leistungshalbleitermodul drei erste und drei zweite Kontaktelektroden aufweist, so dass das Leistungshalbleitermodulsystem eine Gesamtzahl von zwölf Kontaktelektroden aufweist.

Es ist natürlich auch möglich, dass das Leistungshalbleitermodulsystem zusätzliche Kontaktierungsbereiche aufweist, um die Kontaktelektroden an zusätzlichen Bereichen (ggf. indirekt über eine Verschienung) mit dem Gehäuse befestigen zu können, um unter anderem eine Stabilität einer Verbindung des Gehäuses zu den übrigen Komponenten des Leistungshalbleitermodulsystems zu erhöhen.

Im Rahmen einer vorteilhaften Weiterbildung der Erfindung sind die die erste Kontaktelektrode und die zweite Kontaktelektrode jeweils um wenigstens eine Kante des Gehäuses biegbar sind. Dabei weisen die Kanten vorzugsweise eine Abrundung auf, um das Biegen der Kontaktelektroden zu erleichtern. Die Kanten sind vorteilhafterweise im Bereich der Ausnehmungen ausgebildet, durch welche die Kontaktelektroden jeweils durch das Gehäuse nach außen geführt sind. Mit anderen Worten können die Kontaktelektroden, die nach dem Durchführen durch die Ausnehmungen in dem Gehäuse beispielsweise lotrecht zu einer Außenseite des Gehäuses ausgebildet sind, in eine "waagrechte" Position an die Außenseite des Gehäuses gebogen werden. In den Kontaktierungsbereichen können die dorthin gebogenen Kontaktelektroden dann mit einer externen Spannungs-/Stromquelle kontaktiert werden.

In dem Bereich der Ausnehmungen, in dem die Kontaktelektroden durch das Gehäuse nach außen geführt sind, können diese von einem elektrisch isolierenden Material umgeben sein. Diese Material kann beispielsweise in die Ausnehmungen hineingespritzt sein.

Im Zuge einer besonders bevorzugten Weiterbildung der Erfindung weist das Gehäuse in den Kontaktierungsbereichen jeweils eine Ausnehmung zur Aufnahme einer Schraube auf, in welcher vorzugsweise ein Gewindeteil eingesetzt ist, wobei die Ausnehmung, und vorzugsweise das Gewindeteil, zur Aufnahme einer Schraube ausgebildet sind, um die Kontaktelektroden jeweils in dem Kontaktierungsbereich mit einer externen Spannungs-/Stromquelle zu kontaktieren, vorzugsweise an einer Außenseite des Gehäuses, wobei die Kontaktelektroden vorzugsweise ebenfalls eine entsprechende Ausnehmung (bevorzugt ein "Bohrloch") zur Aufnahme der Schraube aufweisen. Es gibt vergleichbare Befestigungsmöglichkeiten, aber die Schraubverbindung stellt eine gängige und gut geeignete Methode dar, um Materialien wie die Kontaktelektroden und die externe Spannungs-/Stromquelle miteinander zu verbinden. Zur Sicherung der Schraubverbindung kann das entsprechende Gewindeteil (an einer Innenseite des Gehäuses angeordnet) verwendet werden. Das Gewindeteil kann beispielsweise eine Mutter sein. Um Toleranzen auszugleichen, können die Ausnehmungen in den Kontaktelektroden jeweils als ein länglich ausgedehntes Loch ausgebildet sein (ein sogenanntes Langloch).

Bevorzugt ist das Gehäuse im Wesentlichen quaderförmig mit vier Längsseiten mit einer größeren Fläche und zwei Stirnseiten mit einer kleineren Fläche ausgebildet, wobei sich die Kontaktierungsbereiche in einem mittigen Bereich einer der vier Längsseiten befinden. Mit anderen Worten sind die Kontaktierungsbereiche mittig in dem Gehäuse angeordnet. Hierdurch ergeben sich die folgenden Vorteile:
- Innerhalb der einzelnen Leistungshalbleitermodule ist ein symmetrisches Layout möglich → dieses eignet sich besonders für Parallelschaltungen von Halbleiterchips;
- Innerhalb der beiden Leistungshalbleitermodule bilden sich keine langen Leiterstrukturen aus, so dass sich die beiden Leistungshalbleitermodule nur minimal gegenseitig beeinflussen.

Die zuvor gestellte Aufgabe wird zudem gelöst durch ein Gehäuse für ein Leistungshalbleitermodulsystem, wobei das Leistungshalbleitermodulsystem wie zuvor erläutert ausgebildet ist.

Außerdem wird die zuvor gestellte Aufgabe gelöst durch einen Leistungshalbleitermodulsystemzusammenschluss mit einer Vielzahl von Leistungshalbleitermodulsystemen, die wie zuvor erläutert ausgebildet sind.

Die Aufgabe wird außerdem gelöst durch ein Verfahren zum Herstellen eines Leistungshalbleitermodulsystems mit den folgenden Verfahrensschritten:
a) Herstellen eines ersten Leistungshalbleitermoduls und eines zweiten Leistungshalbleitermoduls, wobei die Leistungshalbleitermodule jeweils eine Leistungshalbleiterschaltung aufweisen;
b) Verbinden einer ersten Kontaktelektrode und einer zweiten Kontaktelektrode mit der jeweiligen Leistungshalbleiterschaltung, vorzugsweise mittels Löten oder Ultraschallschweißen;
c) Wenigstens teilweises Umgeben der beiden Leistungshalbleitermodule mit einem gemeinsamen Gehäuse, wobei die erste Kontaktelektrode und die zweite Kontaktelektrode der beiden Leistungshalbleitermodule jeweils durch eine hierfür ausgebildete Ausnehmung in dem gemeinsamen Gehäuse durch das gemeinsame Gehäuse nach außen geführt werden, und wobei das gemeinsame Gehäuse einen ersten Kontaktierungsbereich, einen zweiten Kontaktierungsbereich und einen dritten Kontaktierungsbereich aufweist, und wobei in dem ersten Kontaktierungsbereich die erste Kontaktelektrode und die zweite Kontaktelektrode des ersten Leistungshalbleitermoduls zusammen kontaktiert sind, und in dem zweiten Kontaktierungsbereich die erste und die zweite Kontaktelektrode des zweiten Leistungshalbleitermoduls zusammen kontaktiert sind, und in dem dritten Kontaktierungsbereich die zweite Kontaktelektrode des ersten Leistungshalbleitermoduls und die zweite Kontaktelektrode des zweiten Leistungshalbleitermoduls zusammen kontaktiert sind.

In einem zusätzlichen Schritt können die erste Kontaktelektrode des ersten Leistungshalbleitermoduls und die zweite Kontaktelektrode des ersten Leistungshalbleitermoduls gebogen und zusammen in dem ersten Kontaktierungsbereich des gemeinsamen Gehäuses mit einer externen Spannungs-/Stromquelle kontaktiert, und die erste Kontaktelektrode des zweiten Leistungshalbleitermoduls und die zweite Kontaktelektrode des zweiten Leistungshalbleitermoduls gebogen und zusammen in dem zweiten Kontaktierungsbereich des gemeinsamen Gehäuses mit einer externen Spannungs-/Stromquelle kontaktiert, und die zweite Kontaktelektrode des ersten Leistungshalbleitermoduls und die zweite Kontaktelektrode des zweiten Leistungshalbleitermoduls gebogen und zusammen in dem dritten Kontaktierungsbereich des gemeinsamen Gehäuses mit einer externen Spannungs-/Stromquelle kontaktiert werden, wobei die Kontaktierung jeweils vorzugsweise mit Hilfe einer Schraube erfolgt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Es zeigen:
- FIG 1: ein erfindungsgemäßes Leistungshalbleitermodulsystem in einem Querschnitt gemäß einem ersten Aspekt;
- FIG 2: ein erfindungsgemäßes Leistungshalbleitermodulsystem in einem Querschnitt gemäß einem zweiten Aspekt;
- FIG 3: ein erfindungsgemäßes Leistungshalbleitermodulsystem in einer Draufsicht; und
- FIG 4: ein erfindungsgemäßes Leistungshalbleitermodulsystem in einem Querschnitt.

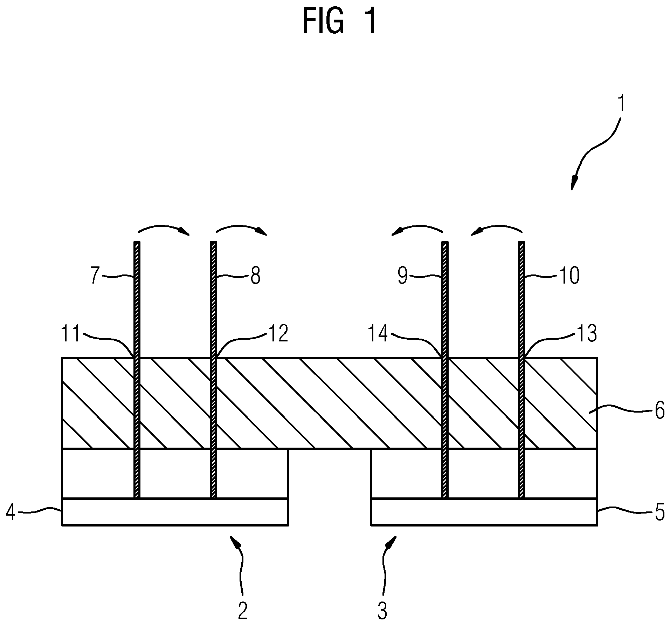

FIG 1 zeigt ein erfindungsgemäßes Leistungshalbleitermodulsystem 1 in einem Querschnitt. Das Leistungshalbleitermodulsystem 1 weist zwei Leistungshalbleitermodule 2, 3 auf. Jedes Leistungshalbleitermodul 2, 3 weist jeweils eine Leistungshalbleiterschaltung 4, 5 auf. Die beiden Leistungshalbleitermodule 2, 3 weisen ein gemeinsames Gehäuse 6 auf, welches die Leistungshalbleiterschaltungen 4, 5 in dessen Innerem wenigstens teilweise umgibt.

Das erste Leistungshalbleitermodul 2 weist eine erste Kontaktelektrode 7 und eine zweite Kontaktelektrode 8 auf. Das zweite Leistungshalbleitermodul 3 weist ebenfalls eine erste Kontaktelektrode 9 und eine zweite Kontaktelektrode 10 auf. Die Kontaktelektroden 7, 8, 9, 10 sind jeweils mit der jeweiligen Leistungshalbleiterschaltung 4, 5 elektrisch leitend verbunden.

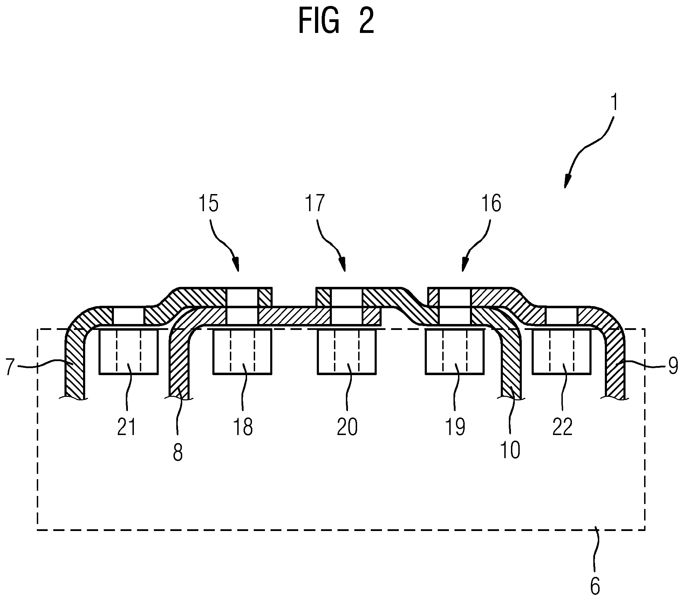

Die Kontaktelektroden 7, 8, 9, 10 sind durch entsprechend ausgebildete Ausnehmungen 11, 12, 13, 14 durch das Gehäuse 6 nach außen geführt. Nach dem Durchführen durch das Gehäuse 6 können die Kontaktelektroden 7, 8, 9, 10 derart umgebogen werden, dass sie im Wesentlichen plan an einer Außenseite des Gehäuses 6 anliegen. Dieser Aspekt ist in FIG 2 verdeutlicht. Das Gehäuse 6 ist hierbei nur mit einer gestrichelten Linie angedeutet. Es weist einen ersten Kontaktierungsbereich 15, einen zweiten Kontaktierungsbereich 16 und einen dritten Kontaktierungsbereich 17 auf. In dem ersten Kontaktierungsbereich 15 können die erste Kontaktelektrode 7 und die zweite Kontaktelektrode 8 des ersten Leistungshalbleitermoduls 4 zusammen mit einer externen Spannungs-/Stromquelle (nicht dargestellt) kontaktiert werden. In dem zweiten Kontaktierungsbereich 16 können die erste Kontaktelektrode 9 und die zweite Kontaktelektrode 10 des zweiten Leistungshalbleitermoduls 5 zusammen mit einer externen Spannungs-/Stromquelle (nicht dargestellt) kontaktiert werden. In dem dritten Kontaktierungsbereich 17 können die zweite Kontaktelektrode 8 des ersten Leistungshalbleitermoduls 4 und die zweite Kontaktelektrode 10 des zweiten Leistungshalbleitermoduls 5 zusammen mit einer externen Spannungs-/Stromquelle (nicht dargestellt) kontaktiert werden.

In den Kontaktelektroden 7, 8, 9, 10 befindet sich jeweils eine kreisförmige Ausnehmung, durch die eine Schraube führbar ist, um die Kontaktelektroden 7, 8, 9, 10 mit einer externen Spannungs-/Stromquelle zu kontaktieren. Zudem weist das Gehäuse 6 in den Kontaktierungsbereichen 15, 16, 17 jeweils eine entsprechende Ausnehmung zur Aufnahme der Schraube auf. Außerdem ist in dem Gehäuse 6 in den Kontaktierungsbereichen 15, 16, 17 jeweils eine Mutter als ein Gewindeteil 18, 19, 20 eingesetzt, in welches die Schrauben zur Fixierung der Kontaktierungen eingeführt werden können. Die Muttern 18, 19, 20 können auch in das Gehäuse 6 mit eingespritzt worden sein. Zwei weitere Muttern 21, 22 können zusätzlich dazu verwendet werden, die erste Kontaktelektrode 7 des ersten Leistungshalbleitermoduls 4 und die erste Kontaktelektrode 9 des zweiten Leistungshalbleitermoduls 5 an dem Gehäuse 6 zu befestigen.

In FIG 2 ist zu erkennen, dass alle vier Kontaktelektroden 7, 8, 9, 10 elektrisch leitende miteinander verbunden sind. Für eine zu kontaktierende externe Strom-/Spannungsquelle fungieren die vier Kontaktelektroden 7, 8, 9, 10 demnach wie eine einzige elektrische Kontaktierung gleichen elektrischen Potentials.

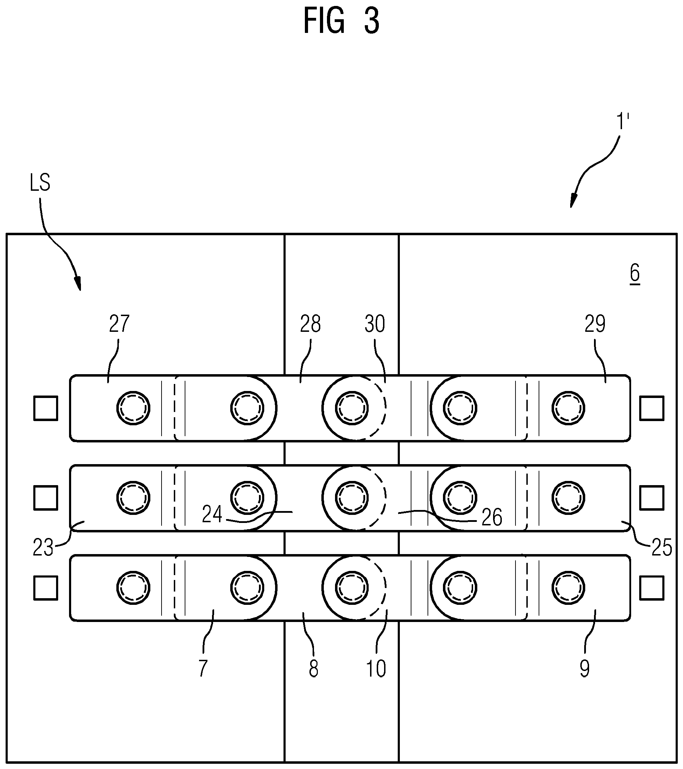

Das Leistungshalbleitermodulsystem 1 ist nicht auf drei Kontaktierungsbereiche 15, 16, 17 und vier Kontaktelektroden 7, 8, 9, 10 beschränkt. In FIG 3 ist eine Draufsicht auf ein Leistungshalbleitermodulsystem 1' dargestellt. Dieses Leistungshalbleitermodulsystem 1' weist ein ganzzahliges (dreifaches) Vielfaches von zwei ersten Kontaktelektroden 7, 9, 23, 25, 27, 29 und zwei zweiten Kontaktelektroden 8, 10, 24, 26, 28, 30 auf, so dass das Leistungshalbleitermodulsystem 1' insgesamt zwölf Kontaktelektroden 7, 8, 9, 10, 23, 24, 25, 26, 27, 28, 29, 30 aufweist. Zudem weist das Leistungshalbleitersystem 1' ein ganzzahliges (dreifaches) Vielfaches von drei Kontaktierungsbereichen 15, 16, 17 auf (aus Übersichtlichkeitsgründen sind diese in FIG 3 nicht mit Bezugszeichen versehen).

Das Gehäuse 6 ist im Wesentlichen quaderförmig mit vier Längsseiten mit einer größeren Fläche und zwei Stirnseiten mit einer kleineren Fläche ausgebildet. In der Draufsicht der FIG 3 ist eine der vier Längsseiten LS mit einer relativ größeren Fläche dargestellt. Die Kontaktierungsbereiche 15, 16, 17 befinden sich in einem mittigen Bereich der Längsseite LS.

In FIG 3 ist zu erkennen, dass jeweils vier Kontaktelektroden 7, 8, 9, 10 bzw. 23, 24, 25, 26 bzw. 27, 28, 29, 30 elektrisch leitend miteinander verbunden sind. Für eine zu kontaktierende externe Strom-/Spannungsquelle fungieren die dreimal vier Kontaktelektroden 7, 8, 9, 10, 23, 24, 25, 26, 27, 28, 29, 30 demnach wie drei elektrische Kontaktierungen mit jeweils gleichem elektrischem Potential.

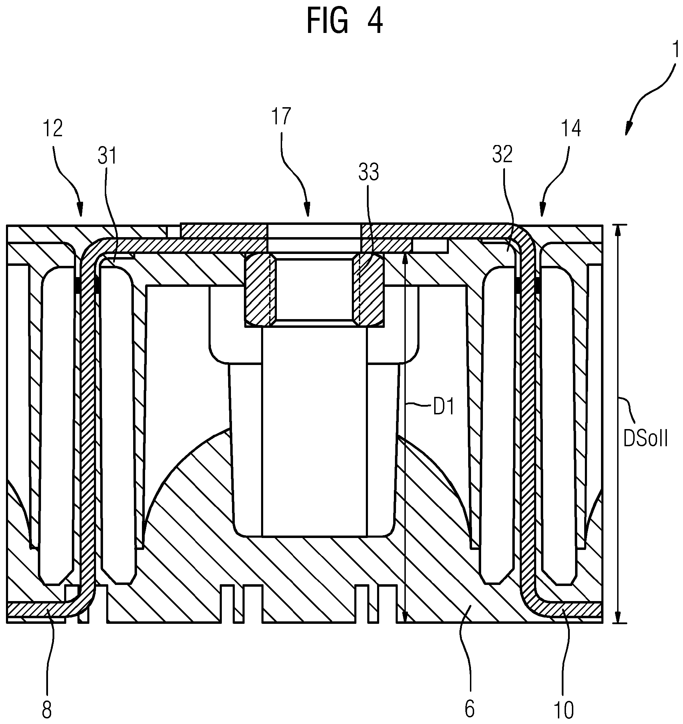

In FIG 4 ist ein Querschnitt des Gehäuses 6 eines erfindungsgemäßen Leistungshalbleitermodulsystems 1 dargestellt. Es sind die zweite Kontaktelektrode 8 des ersten Leistungshalbleitermoduls 4 und die zweite Kontaktelektrode 10 des zweiten Leistungshalbleitermodulsystems 5 zu erkennen. Die beiden Kontaktelektroden 8, 10 sind durch das Gehäuse 6 nach außen hindurchgeführt und jeweils um eine Kante 31, 32 des Gehäuses 6 gebogen. Die Kanten 31, 32 weisen jeweils eine Abrundung auf, um das Biegen der Kontaktelektroden 8, 10 um die Kanten 31, 32 zu erleichtern.

In einem Bereich der Ausnehmungen 12, 14, durch welche die Kontaktelektroden 8, 10 durch das Gehäuse 6 nach außen geführt sind, sind diese von einem elektrisch isolierenden Material umgeben. In den Ausnehmungen 12, 14 sind die beiden Kontaktelektroden 8, 10 damit geführt, wodurch die beim Biegen entstehenden Kräfte gut aufgenommen werden können, ohne eine Verbindung der Kontaktelektroden 8, 10 zu der jeweiligen Leistungshalbleiterschaltung 2, 3 zu beschädigen.

In dem in FIG 4 dargestellten dritten Kontaktierungsbereich 17 des Gehäuses 6, in dem die beiden Kontaktelektroden 8, 10 übereinander mit einer externen Spannungs-/Stromquelle (nicht dargestellt) kontaktierbar sind, ist eine Dicke D1 des Gehäuses 6 so ausgebildet, dass er einer Solldicke DSoll des Gehäuses 6 abzüglich der Summe der Querschnitte der beiden Kontaktelektroden 8, 10 entspricht. Mit anderen Worten ist das Gehäuse 6 in dem dritten Kontaktierungsbereich 17 so vertieft, dass es bei einer Anordnung beider Kontaktelektroden 8, 10 in diesem Bereich zu einer effektiven Dicke des Gehäuses 6 kommt, welche dieses einheitlich nach außen aufweisen soll.

Entsprechend sind der erste Kontaktierungsbereich 15 und der zweite Kontaktierungsbereich 16 (in FIG 4 nicht dargestellt) jeweils um einen summierten Querschnitt der ersten Kontaktelektrode 7 und der zweiten Kontaktelektrode 8 des ersten Leistungshalbleitermoduls 4 bzw. der ersten Kontaktelektrode 9 und der zweiten Kontaktelektrode 10 des zweiten Leistungshalbleitermoduls 5 gegenüber der Solldicke DSoll vertieft (in FIG 4 nicht dargestellt).

Das Gehäuse 6 weist in dem dritten Kontaktierungsbereich 17 eine Ausnehmung auf, in welcher ein Gewindeteil 33 in Form einer Mutter eingesetzt ist, wobei die Ausnehmung und das Gewindeteil zur Aufnahme einer Schraube ausgebildet sind, um die Kontaktelektroden 8, 10 in dem dritten Kontaktierungsbereich 17 mit einer externen Spannungs-/Stromquelle zu kontaktieren.

In der Ausnehmung 12, durch welche die zweite Kontaktelektrode 8 des ersten Leistungshalbleitermoduls 4 durch das Gehäuse 6 nach außen geführt ist, fungiert eine Wandung der Ausnehmung 12 als seitliche Führung (durch Pfeile gekennzeichnet), die die beim Biegen der Kontaktelektrode 8 entstehenden Kräfte aufnimmt und insbesondere die Verbindung der Kontaktelektrode 8 zu der Leistungshalbleiterschaltung 4 vor einer Beschädigung bewahrt. Die übrigen Ausnehmungen 11, 13, 14 für die übrigen Kontaktelektroden 7, 9, 10 sind vergleichbar ausgebildet.

## Patentansprüche

1. Leistungshalbleitermodulsystem (1, 1'), welches ein erstes Leistungshalbleitermodul (4) und ein zweites Leistungshalbleitermodul (5) mit einem gemeinsamen Gehäuse (6) aufweist, wobei jedes Leistungshalbleitermodul (4, 5) eine Leistungshalbleiterschaltung (2, 3) aufweist, und wobei das gemeinsame Gehäuse (6) die beiden Leistungshalbleiterschaltungen (2, 3) wenigstens teilweise umgibt,
und wobei die Leistungshalbleitermodule (4, 5) jeweils eine erste Kontaktelektrode (7, 9, 23, 25, 27, 29) und eine zweite Kontaktelektrode (8, 10, 24, 26, 28, 30) aufweisen, die jeweils mit der Leistungshalbleiterschaltung (2, 3) elektrisch leitend verbunden sind, und die jeweils durch eine hierfür ausgebildete Ausnehmung (11, 12, 13, 14) in dem gemeinsamen Gehäuse (6) durch das Gehäuse (6) nach außen geführt sind,
wobei das gemeinsame Gehäuse (6) einen ersten Kontaktierungsbereich (15), einen zweiten Kontaktierungsbereich (16) und einen dritten Kontaktierungsbereich (17) aufweist,
wobei in dem ersten Kontaktierungsbereich (15) die erste Kontaktelektrode (7, 23, 27) und die zweite Kontaktelektrode (8, 24, 28) des ersten Leistungshalbleitermoduls (4) zusammen kontaktiert sind,
und wobei in dem zweiten Kontaktierungsbereich (16) die erste Kontaktelektrode (9, 25, 29) und die zweite Kontaktelektrode (10, 26, 30) des zweiten Leistungshalbleitermoduls (5) zusammen kontaktiert sind,
und wobei in dem dritten Kontaktierungsbereich (17) die zweite Kontaktelektrode (8, 24, 28) des ersten Leistungshalbleitermoduls (4) und die zweite Kontaktelektrode (10, 26, 30) des zweiten Leistungshalbleitermoduls (5) zusammen kontaktiert sind.

2. Leitungshalbleitermodulsystem (1, 1') nach Anspruch 1, bei dem in dem ersten Kontaktierungsbereich (15) die erste Kontaktelektrode (7, 23, 27) und die zweite Kontaktelektrode (8, 24, 28) des ersten Leistungshalbleitermoduls (4) zusammen mit einer externen Spannungs-/Stromquelle kontaktiert sind,
und in dem zweiten Kontaktierungsbereich (16) die erste Kontaktelektrode (9, 25, 29) und die zweite Kontaktelektrode (10, 26, 30) des zweiten Leistungshalbleitermoduls (5) zusammen mit einer externen Spannungs-/Stromquelle kontaktiert sind,
und in dem dritten Kontaktierungsbereich (17) die zweite Kontaktelektrode (8, 24, 28) des ersten Leistungshalbleitermoduls (4) und die zweite Kontaktelektrode (10, 26, 30) des zweiten Leistungshalbleitermoduls (5) zusammen mit einer externen Spannungs-/Stromquelle kontaktiert sind.

3. Leistungshalbleitermodulsystem (1, 1') nach Anspruch 1 oder 2, das ein ganzzahliges Vielfaches von zwei ersten Kontaktelektroden (7, 9, 23, 25, 27, 29) und zwei zweiten Kontaktelektroden (8, 10, 24, 26, 28, 30) und ein Vielfaches von drei Kontaktierungsbereichen (15, 16, 17) aufweist, wobei die Kontaktelektroden (7, 8, 9, 10, 23, 24, 25, 26, 27, 28, 29, 30) und die Kontaktierungsbereiche (15, 16, 17) an dem Gehäuse (6) jeweils gemäß Anspruch 1 oder 2 ausgebildet sind.

4. Leistungshalbleitermodulsystem (1, 1') nach einem der vorangegangenen Ansprüche, bei dem die erste Kontaktelektrode (7, 9, 23, 25, 27, 29) und die zweite Kontaktelektrode (8, 10, 24, 26, 28, 30) jeweils um wenigstens eine Kante (31, 32) des Gehäuses (6) gebogen sind.

5. Leistungshalbleitermodulsystem (1, 1') nach Anspruch 4, bei dem die Kanten (31, 32) eine Abrundung aufweisen, um das Biegen der Kontaktelektroden (7, 8, 9, 10, 23, 24, 25, 26, 27, 28, 29, 30) zu erleichtern.

6. Leistungshalbleitermodulsystem (1, 1') nach einem der vorangegangenen Ansprüche, bei dem die Kontaktelektroden (7, 8, 9, 10, 23, 24, 25, 26, 27, 28, 29, 30) in einem Bereich der Ausnehmungen (11, 12, 13, 14), durch welche die Kontaktelektroden (7, 8, 9, 10, 23, 24, 25, 26, 27, 28, 29, 30) durch das Gehäuse (6) nach außen geführt sind, von einem elektrisch isolierenden Material umgeben sind.

7. Leistungshalbleitermodulsystem (1, 1') nach einem der vorangegangenen Ansprüche, bei dem das Gehäuse (6) in den Kontaktierungsbereichen (15, 16, 17) jeweils eine Ausnehmung aufweist, in welcher vorzugsweise ein Gewindeteil (33) eingesetzt ist, wobei die Ausnehmung, und vorzugsweise das Gewindeteil (33), zur Aufnahme einer Schraube ausgebildet sind, um die Kontaktelektroden (7, 8, 9, 10, 23, 24, 25, 26, 27, 28, 29, 30) jeweils in den Kontaktierungsbereichen (15, 16, 17) mit einer externen Spannungs-/Stromquelle zu kontaktieren, vorzugsweise an einer Außenseite des Gehäuses (6), wobei die Kontaktelektroden (7, 8, 9, 10, 23, 24, 25, 26, 27, 28, 29, 30) vorzugsweise ebenfalls eine entsprechende Ausnehmung zur Aufnahme der Schraube aufweisen.

8. Leistungshalbleitermodulsystem (1, 1') nach Anspruch 7, bei dem die Ausnehmungen jeweils als ein länglich ausgedehntes Loch ausgebildet sind.

9. Leistungshalbleitermodulsystem (1, 1') nach einem der vorangegangenen Ansprüche, bei dem das Gehäuse (6) im Wesentlichen quaderförmig mit vier Längsseiten mit einer größeren Fläche und zwei Stirnseiten mit einer kleineren Fläche ausgebildet ist, wobei sich die Kontaktierungsbereiche (15, 16, 17) in einem mittigen Bereich einer der vier Längsseiten befinden.

10. Leistungshalbleitermodulsystemzusammenschluss mit einer Vielzahl von Leistungshalbleitermodulsystemen (1, 1'), die gemäß einem der Ansprüche 1 bis 9 ausgebildet sind.

11. Verfahren zum Herstellen eines Leistungshalbleitermodulsystems (1, 1'), umfassend:
a) Herstellen eines ersten Leistungshalbleitermoduls (4) und eines zweiten Leistungshalbleitermoduls (5), wobei die Leistungshalbleitermodule (4, 5) jeweils eine Leistungshalbleiterschaltung (2, 3) aufweisen;
b) Verbinden einer ersten Kontaktelektrode (7, 9, 23, 25, 27, 29) und einer zweiten Kontaktelektrode (8, 10, 24, 26, 28, 30) mit der jeweiligen Leistungshalbleiterschaltung (2, 3), vorzugsweise mittels Löten oder Ultraschallschweißen;
c) Wenigstens teilweises Umgeben der beiden Leistungshalbleitermodule (4, 5) mit einem gemeinsamen Gehäuse (6), wobei die erste Kontaktelektrode (7, 9, 23, 25, 27, 29) und die zweite Kontaktelektrode (8, 10, 24, 26, 28, 30) der beiden Leistungshalbleitermodule (4, 5) jeweils durch eine hierfür ausgebildete Ausnehmung (11, 12, 13, 14) in dem gemeinsamen Gehäuse (6) durch das gemeinsame Gehäuse (6) nach außen geführt werden,
und wobei das gemeinsame Gehäuse (6) einen ersten Kontaktierungsbereich (15), einen zweiten Kontaktierungsbereich (16) und einen dritten Kontaktierungsbereich (17) aufweist, und
wobei in dem ersten Kontaktierungsbereich (15) die erste Kontaktelektrode (7, 23, 27) und die zweite Kontaktelektrode (8, 24, 28) des ersten Leistungshalbleitermoduls (4) zusammen kontaktiert sind,
und wobei in dem zweiten Kontaktierungsbereich (16) die erste Kontaktelektrode (9, 25, 29) und die zweite Kontaktelektrode (10, 26, 30) des zweiten Leistungshalbleitermoduls (5) zusammen kontaktiert sind,
und wobei in dem dritten Kontaktierungsbereich (17) die zweite Kontaktelektrode (8, 24, 28) des ersten Leistungshalbleitermoduls (4) und die zweite Kontaktelektrode (10, 26, 30) des zweiten Leistungshalbleitermoduls (5) zusammen kontaktiert sind.

12. Verfahren nach Anspruch 11, bei dem die erste Kontaktelektrode (7, 23, 27) des ersten Leistungshalbleitermoduls (4) und die zweite Kontaktelektrode (8, 24, 28) des ersten Leistungshalbleitermoduls (4) gebogen und zusammen in dem ersten Kontaktierungsbereich (15) des gemeinsamen Gehäuses (6) mit einer externen Spannungs-/Stromquelle kontaktiert werden, und die erste Kontaktelektrode (9, 25, 29) des zweiten Leistungshalbleitermoduls (5) und die zweite Kontaktelektrode (10, 26, 30) des zweiten Leistungshalbleitermoduls (5) gebogen und zusammen in dem zweiten Kontaktierungsbereich (16) des gemeinsamen Gehäuses (6) mit einer externen Spannungs-/Stromquelle kontaktiert werden, und die zweite Kontaktelektrode (8, 24, 28) des ersten Leistungshalbleitermoduls (4) und die zweite Kontaktelektrode (10, 26, 30) des zweiten Leistungshalbleitermoduls (5) gebogen und zusammen in dem dritten Kontaktierungsbereich (17) des gemeinsamen Gehäuses (6) mit einer externen Spannungs-/Stromquelle kontaktiert werden, wobei die Kontaktierung jeweils vorzugsweise mit Hilfe einer Schraube erfolgt.

## Claims

1. Power semiconductor module system (1, 1'), which has a first power semiconductor module (4) and a second power semiconductor module (5) with a common housing (6), wherein each power semiconductor module (4, 5) has a power semiconductor circuit (2, 3), and wherein the common housing (6) at least partially surrounds the two power semiconductor circuits (2, 3),
and wherein the power semiconductor modules (4, 5) each have a first contact electrode (7, 9, 23, 25, 27, 29) and a second contact electrode (8, 10, 24, 26, 28, 30), which are each electrically conductively connected to the power semiconductor circuit (2, 3) and which are each guided outwards through the housing (6) through a recess (11, 12, 13, 14) in the common housing (6) made for this purpose,
wherein the common housing (6) has a first contacting region (15), a second contacting region (16) and a third contacting region (17),
wherein in the first contacting region (15) the first contact electrode (7, 23, 27) and the second contact electrode (8, 24, 28) of the first power semiconductor module (4) are contacted together,
and wherein in the second contacting region (16) the first contact electrode (9, 25, 29) and the second contact electrode (10, 26, 30) of the second power semiconductor module (5) are contacted together,
and wherein in the third contacting region (17) the second contact electrode (8, 24, 28) of the first power semiconductor module (4) and the second contact electrode (10, 26, 30) of the second power semiconductor module (5) are contacted together.

2. Power semiconductor module system (1, 1') according to claim 1, in which in the first contacting region (15) the first contact electrode (7, 23, 27) and the second contact electrode (8, 24, 28) of the first power semiconductor module (4) are contacted together with an external voltage/current source,
and in the second contacting region (16) the first contact electrode (9, 25, 29) and the second contact electrode (10, 26, 30) of the second power semiconductor module (5) are contacted together with an external voltage/current source, and in the third contacting region (17) the second contact electrode (8, 24, 28) of the first power semiconductor module (4) and the second contact electrode (10, 26, 30) of the second power semiconductor module (5) are contacted together with an external voltage/current source.

3. Power semiconductor module system (1, 1') according to claim 1 or 2, having an integer multiple of two first contact electrodes (7, 9, 23, 25, 27, 29) and two second contact electrodes (8, 10, 24, 26, 28, 30) and a multiple of three contacting regions (15, 16, 17), wherein the contact electrodes (7, 8, 9, 10, 23, 24, 25, 26, 27, 28, 29, 30) and the contacting regions (15, 16, 17) are each configured on the housing (6) in accordance with claim 1 or 2.

4. Power semiconductor module system (1, 1') according to one of the preceding claims, in which the first contact electrode (7, 9, 23, 25, 27, 29) and the second contact electrode (8, 10, 24, 26, 28, 30) are bent in each case around at least one edge (31, 32) of the housing (6).

5. Power semiconductor module system (1, 1') according to claim 4, in which the edges (31, 32) have a rounding, to facilitate the bending of the contact electrodes (7, 8, 9, 10, 23, 24, 25, 26, 27, 28, 29, 30).

6. Power semiconductor module system (1, 1') according to one of the preceding claims, in which the contact electrodes (7, 8, 9, 10, 23, 24, 25, 26, 27, 28, 29, 30) in a region of the recesses (11, 12, 13, 14), through which the contact electrodes (7, 8, 9, 10, 23, 24, 25, 26, 27, 28, 29, 30) are guided outwards through the housing (6), are surrounded by an electrically insulating material.

7. Power semiconductor module system (1, 1') according to one of the preceding claims, in which the housing (6) has a recess in each of the contacting regions (15, 16, 17), in which a threaded part (33) is preferably inserted, wherein the recess, and preferably the threaded part (33), are designed to receive a screw in order to contact the contact electrodes (7, 8, 9, 10, 23, 24, 25, 26, 27, 28, 29, 30) in each contacting region (15, 16, 17) with an external voltage/current source, preferably on an outer face of the housing (6), wherein the contact electrodes (7, 8, 9, 10, 23, 24, 25, 26, 27, 28, 29, 30) preferably also have a corresponding recess for receiving the screw.

8. Power semiconductor module system (1, 1') according to claim 7, in which the recesses are in each case configured as a longitudinally extended hole.

9. Power semiconductor module system (1, 1') according to one of the preceding claims, in which the housing (6) is configured substantially as a rectangle with four large-area longitudinal sides and two smaller-area end faces, wherein the contacting regions (15, 16, 17) are located in a central region of one of the four longitudinal sides.

10. Power semiconductor module system assembly with a plurality of power semiconductor module systems (1, 1'), configured in accordance with one of claims 1 to 9.

11. Method for producing a power semiconductor module system (1, 1'), comprising:
a) Producing a first power semiconductor module (4) and a second power semiconductor module (5), wherein the power semiconductor modules (4, 5) each have a power semiconductor circuit (2, 3);
b) Connecting a first contact electrode (7, 9, 23, 25, 27, 29) and a second contact electrode (8, 10, 24, 26, 28, 30) with the respective power semiconductor circuit (2, 3), preferably by means of soldering or ultrasound welding;
c) At least partially surrounding the two power semiconductor modules (4, 5) with a common housing (6), wherein the first contact electrode (7, 9, 23, 25, 27, 29) and the second contact electrode (8, 10, 24, 26, 28, 30) of the two power semiconductor modules (4, 5) are each guided outwards through the common housing (6) through a recess (11, 12, 13, 14) in the common housing (6) made for this purpose,
and wherein the common housing (6) has a first contacting region (15), a second contacting region (16) and a third contacting region (17), and
wherein in the first contacting region (15) the first contact electrode (7, 23, 27) and the second contact electrode (8, 24, 28) of the first power semiconductor module (4) are contacted together,
and wherein in the second contacting region (16) the first contact electrode (9, 25, 29) and the second contact electrode (10, 26, 30) of the second power semiconductor module (5) are contacted together,
and wherein in the third contacting region (17) the second contact electrode (8, 24, 28) of the first power semiconductor module (4) and the second contact electrode (10, 26, 30) of the second power semiconductor module (5) are contacted together.

12. Method according to claim 11, in which the first contact electrode (7, 23, 27) of the first power semiconductor module (4) and the second contact electrode (8, 24, 28) of the first power semiconductor module (4) are bent and contacted together in the first contacting region (15) of the common housing (6) with an external voltage/current source, and the first contact electrode (9, 25, 29) of the second power semiconductor module (5) and the second contact electrode (10, 26, 30) of the second power semiconductor module (5) are bent and contacted together in the second contacting region (16) of the common housing (6) with an external voltage/current source, and the second contact electrode (8, 24, 28) of the first power semiconductor module (4) and the second contact electrode (10, 26, 30) of the second power semiconductor module (5) are bent and contacted together in the third contacting region (17) of the common housing (6) with an external voltage/current source, wherein the contacting in each case takes place preferably with the help of a screw.

## Revendications

1. Système (1, 1') de modules à semiconducteur de puissance, qui a un premier module (4) à semiconducteur de puissance et un deuxième module (5) à semiconducteur de puissance ayant un boîtier (6) commun, dans lequel chaque module (4, 5) à semiconducteur de puissance a un circuit (2, 3) à semiconducteur de puissance, et dans lequel le boîtier (6) commun entoure au moins en partie les deux circuits (2, 3) à semiconducteur de puissance,
et dans lequel les modules (4, 5) à semiconducteur de puissance ont chacun une première électrode (7, 9, 23, 25, 27, 29) de contact et une deuxième électrode (8, 10, 24, 26, 28, 30) de contact, qui sont connectées d'une manière conductrice de l'électricité respectivement au circuit (2, 3) à semiconducteur de puissance et qui passent chacune à l'extérieur, en passant à travers le boîtier (6), par l'intermédiaire d'un évidement (11, 12, 13, 14) constitué à cet effet dans le boîtier (6) commun,
dans lequel le boîtier (6) commun a une première partie (15) de mise en contact, une deuxième partie (16) de mise en contact et une troisième partie (17) de mise en contact,
dans lequel, dans la première partie (15) de mise en contact, la première électrode (7, 23, 27) de contact et la deuxième électrode (8, 24, 28) de contact du premier module (4) à semiconducteur de puissance sont mises ensemble en contact,
et dans lequel, dans la deuxième partie (16) de mise en contact, la première électrode (9, 25, 29) de contact et la deuxième électrode (10, 26, 30) de contact du deuxième module (5) à semiconducteur de puissance sont mises ensemble en contact,
et dans lequel, dans la troisième partie (17) de mise en contact, la deuxième électrode (8, 24, 28) de contact du premier module (4) à semiconducteur de puissance et la deuxième électrode (10, 26, 30) de contact du deuxième module (5) à semiconducteur de puissance sont mises en contact ensemble.

2. Système (1, 1') de modules à semiconducteur de puissance suivant la revendication 1, dans lequel, dans la première partie (15) de mise en contact, la première électrode (7, 23, 27) de contact et la deuxième électrode (8, 24, 28) de contact du premier module (4) à semiconducteur de puissance sont mises en contact ensemble avec une source extérieure de tension et/ou courant,
et dans la deuxième partie (16) de mise en contact, la première électrode (9, 25, 29) de contact et la deuxième électrode (10, 26, 30) de contact du deuxième module (5) à semiconducteur de puissance sont mises en contact ensemble avec une première source de tension / courant,
et dans la troisième partie (17) de mise en contact, la deuxième électrode (8, 24, 28) de contact du premier module (4) à semiconducteur de puissance et la deuxième électrode (10, 26, 30) de contact du deuxième module (5) à semiconducteur de puissance sont mises en contact ensemble avec une source extérieure de tension / courant.

3. Système (1, 1') de modules à semiconducteur de puissance suivant l'une des revendications 1 ou 2, qui a un multiple en nombre entier de deux premières électrodes (7, 9, 23, 25, 27, 29) de contact et de deux deuxièmes électrodes (8, 10, 24, 26, 28, 30) de contact et un multiple de trois parties (15, 16, 17) de mise en contact, dans lequel les électrodes (7, 8, 9, 10, 23, 24, 25, 26, 27, 28, 29, 30) de contact et les parties (15, 16, 17) de mise en contact sont constituées sur le boîtier (6) chacune conformément à la revendication 1 ou 2.

4. Système (1, 1') de modules à semiconducteur de puissance suivant l'une des revendications précédentes, dans lequel les premières électrodes (7, 9, 23, 25, 27, 29) de contact et les deuxièmes électrodes (8, 10, 24, 26, 28, 30) de contact sont courbées respectivement autour d'au moins un bord (31, 32) du boîtier (6).

5. Système (1, 1') de modules à semiconducteur de puissance suivant la revendication 4, dans lequel les bords (31, 32) ont un arrondi afin de faciliter la flexion des électrodes (7, 8, 9, 10, 23, 24, 25, 26, 27, 28, 29, 30) de contact.

6. Système (1, 1') de modules à semiconducteur de puissance suivant l'une des revendications précédentes, dans lequel les électrodes (7, 8, 9, 10, 23, 24, 25, 26, 27, 28, 29, 30) de contact sont entourées d'un matériau isolant électriquement dans une partie des évidements (11, 12, 13, 14), par lesquels les électrodes (7, 8, 9, 10, 23, 24, 25, 26, 27, 28, 29, 30) de contact passent vers l'extérieur en traversant le boîtier (6).

7. Système (1, 1') de modules à semiconducteur de puissance suivant l'une des revendications précédentes, dans lequel le boîtier (6) a, dans les parties (15, 16, 17) de mise en contact, respectivement un évidement, dans lequel est inséré, de préférence, une partie (33) filetée, dans lequel l'évidement et, de préférence, la partie (33) filetée sont constitués pour la réception d'une vis afin de mettre les électrodes (7, 8, 9, 10, 23, 24, 25, 26, 27, 28, 29, 30) de contact chacune dans les parties (15, 16, 17) de mise en contact en contact avec une source extérieure de tension / courant, de préférence sur un côté extérieur du boîtier (6), dans lequel les électrodes (7, 8, 9, 10, 23, 24, 25, 26, 27, 28, 29, 30) de contact ont, de préférence, également un évidement correspondant pour la réception de la vis.

8. Système (1, 1') de modules à semiconducteur de puissance suivant la revendication 7, dans lequel les évidements sont constitués respectivement sous la forme de trous oblongs.

9. Système (1, 1') de modules à semiconducteur de puissance suivant l'une des revendications précédentes, dans lequel le boîtier (6) est sensiblement parallélépipédique, ayant quatre faces longitudinales d'une surface plus grande et deux faces frontales d'une surface plus petite, dans lequel les parties (15, 16, 17) de mise en contact se trouvent dans une partie médiane de l'une des quatre faces longitudinales.

10. Mise en commun de systèmes de modules à semiconducteur de puissance comprenant une pluralité de systèmes (1, 1') de modules à semiconducteur de puissance, qui sont constitués suivant l'une des revendications 1 à 9.

11. Procédé de fabrication d'un système (1, 1') de modules de semiconducteur de puissance, comprenant :
a) fabrication d'un premier module (4) à semiconducteur de puissance et d'un deuxième module (5) à semiconducteur de puissance, dans lequel les modules (4, 5) à semiconducteur de puissance ont chacun un circuit (2, 3) à semiconducteur de puissance ;
b) connexion d'une première électrode (7, 9, 23, 25, 27, 29) de contact et d'une deuxième électrode (8, 10, 24, 26, 28, 30) de contact au circuit (2, 3) respectif à semiconducteur de puissance, de préférence au moyen d'une brasure ou d'une soudure par ultrasons ;
c) entourage au moins en partie des deux modules (4, 5) à semiconducteur de puissance par un boîtier (6) commun, dans lequel on fait passer, vers l'extérieur, en passant à travers le boîtier (6) commun, la première électrode (7, 9, 23, 25, 27, 29) de contact et la deuxième électrode (8, 10, 24, 26, 28, 30) de contact des deux modules (4, 5) à semiconducteur de puissance, chacune en passant par un évidement (11, 12, 13, 14) constitué à cet effet dans le boîtier (6) commun ,
et dans lequel le boîtier (6) commun a une première partie (15) de mise en contact, une deuxième partie (16) de mise en contact et une troisième partie (17) de mise en contact, et
dans lequel, dans la première partie (15) de mise en contact, la première électrode (7, 23, 27) de contact et la deuxième électrode (8, 24, 28) de contact du premier module (4) à semiconducteur de puissance sont mises ensemble en contact,
et dans lequel, dans la deuxième partie (16) de mise en contact, la première électrode (9, 25, 29) de contact et la deuxième électrode (10, 26, 30) de contact du deuxième module (5) à semiconducteur de puissance sont mises ensemble en contact,
et dans lequel, dans la troisième partie (17) de mise en contact, la deuxième électrode (8, 24, 28) de contact du premier module (4) à semiconducteur de puissance et la deuxième électrode (10, 26, 30) de contact du deuxième module (5) à semiconducteur de puissance sont mises en contact ensemble.

12. Procédé suivant la revendication 11, dans lequel on courbe la première électrode (7, 23, 27) de contact du premier module (4) à semiconducteur de puissance et la deuxième électrode (8, 24, 28) de contact du premier module (4) à semiconducteur de puissance et on les met en contact avec une source extérieure de tension / courant ensemble dans une première partie (15) de mise en contact du boîtier (6), et on courbe la première électrode (9, 25, 29) de contact du deuxième module (5) à semiconducteur de puissance et la deuxième électrode (10, 26, 30) de contact du deuxième module (5) à semiconducteur de puissance et on les met en contact avec une source extérieure de tension / courant ensemble dans la deuxième partie (16) de mise en boîtier (6) commun, et on courbe la deuxième électrode (8, 24, 28) de contact du premier module (4) à semiconducteur de puissance et la deuxième électrode (10, 26, 30) de contact du deuxième module (5) à semiconducteur de puissance et on les met en contact avec une source extérieure de tension / courant ensemble dans la troisième partie (17) de mise en contact du boîtier (6) commun, la mise en contact s'effectuant respectivement de préférence à l'aide d'une vis.
